# EUROPÄISCHE PATENTSCHRIFT

(11) **EP 0 827 279 B1**
(45) Veröffentlichungstag und Bekanntmachung des Hinweises auf die Patenterteilung: **06.03.2002**
(21) Anmeldenummer: 97113379.8
(22) Anmeldetag: 02.08.1997
(51) Int. Cl.: H03K 17/14, H03K 17/04, H01F 7/18, F02D 41/20, H03K 17/0814

(54) **Schaltungsanordnung zum voneinander unabhängigen Schalten mehrerer, paralleler induktiver Schalteinheiten**
Circuit for switching multiple parallel switching devices with inductive loads independently of each other
Circuit pour commuter indépendamment l'une de l'autre une pluralité de commutateurs parallèles avec charges inductives

(30) Priorität: 10.08.1996 DE 19632365
(43) Veröffentlichungstag der Anmeldung: 04.03.1998
(73) Patentinhaber: Conti Temic microelectronic GmbH, 90411 Nürnberg (DE)
(72) Erfinder: Alberter, Günther, 90409 Nürnberg (DE); Breu, Gunther, 90491 Nürnberg (DE); Gutbrod, Wolfgang, 91096 Möhrendorf (DE)
(74) Vertreter: Maute, Hans-Jürgen, Dipl.-Ing.

(56) Entgegenhaltungen:
- EP-A- 0 607 030
- EP-A- 0 711 910
- WO-A-97/04230
- US-A- 4 667 117
- US-A- 5 202 820
- PATENT ABSTRACTS OF JAPAN vol. 014, no. 410 (M-1020), 5. September 1990 & JP 02 158366 A (SEIKO EPSON CORP), 18. Juni 1990

## Beschreibung

Die Erfindung betrifft eine Schaltungsanordnung zum voneinander unabhängigen Schalten mehrerer parallel geschalteter induktiver Schalteinheiten. Eine derartige Schaltungsanordnung ist in der Druckschrift EP 0 607 030 A2 beschrieben.

In Kraftfahrzeuge werden zunehmend Systeme integriert, deren Funktion auf dem schnellen Schalten von induktiven Schalteinheiten mit induktiven Lasten beruht. in der Regel sind diese induktiven Lasten die Induktionsspulen von leistungsstarken, gleichstrombetriebenen Magnetventilen. Zum schnellen Abschalten einer induktiven Last ist es notwendig, die in ihrem Magnetfeld gespeicherte Energie möglichst rasch umzuwandeln.

Eine klassische Schaltungsanordnung, die den Abbau der in einer induktiven Last gespeicherten Energie beschleunigt, ist ein Freilaufschalter in Serie mit einer Freilaufdiode, die zusammen einen Freilaufkreis bilden, über den die induktive Last kurzgeschlossen werden kann, und der parallel zur induktiven Last und ihrem Hauptschalter geschaltet ist. Zum Abschalten der induktiven Last wird, gleichzeitig mit dem Öffnen des Hauptschalters, der Freilaufschalter geschlossen. Dabei fällt die Feldstärke des Magnetfeldes der induktiven Last rasch ab und die Energie des Magnetfeldes wird in Wärmeenergie umgewandelt, wodurch das Abschalten der induktiven Last beschleunigt beendet wird. Allerdings geht dabei die in der induktiven Last gespeicherte Energie vollständig verloren; die verlustleistung der Schaltungsanordnung ist maximal. Zudem muß der Freilaufkreis, insbesondere der Freilaufschalter, für die hohen Spannungsspitzen ausgelegt sein, die beim Kurzschließen der induktiven Last auftreten.

In der gattungsbildenden Druckschrift EP 0 607 030 A2 ist eine als Vier - Quadrantenschaltung bezeichnete Schaltungsanordnung beschrieben, bei der mehrere parallel geschaltete induktive Schalteinheiten, die von einer Gleichspannungsquelle versorgt werden, bei einer minimalen Verlustleistung, unabhängig voneinander geschaltet werden. Ein induktive Schalteinheit besteht dabei aus einer induktiven Last und einem Hauptschalter, zwischen denen eine Sperrdiode kontaktiert ist, die in sperrichtung mit dem Minuspol verbunden ist.

Bei der Vier - Quadrantenschaltung wird die Verlustleistung beim Abschalten der induktiven Last dadurch minimiert, daß der Strom, den die induktiven Lasten in den Stromkreis induzieren, an die Gleichspannungsquelle der Schaltungsanordnung rückgeführt wird. Dazu ist der Freilaufkreis, der mit einer Freilaufdiode parallel zu den induktiven Schalteinheiten geschaltet ist, über einen Freilaufschalter mit dem Minuspol der Gleichspannungsquelle verbunden.
Beim Aktivieren (Bestromen) einer induktiven Last werden der Hauptschalter der betreffenden induktiven Schalteinheit und der Freilaufschalter geschlossen. Dabei fließt ein Strom von der Gleichspannungsquelle über den Hauptschalter und der induktiven Last der betreffende induktiven Schalteinheit über den Freilaufschalter zum Minuspol der Gleichspannungsquelle.
Nach dem Öffnen des Freilaufschalters befindet sich die Schaltungsanordnung in der Freilaufphase, wobei der Strom in einem geschlossenen Stromkreis fließt, der aus dem Hauptschalter und der induktiven Last der betreffenden induktiven Schalteinheit sowie der Freilaufdiode gebildet wird.
Zum Beenden des aktiven Schaltzustandes einer induktiven Schalteinheit wird der Hauptschalter der induktiven Schalteinheit geöffnet. Dadurch induziert die induktive Last einem Strom in einen Stromkreis, der aus der induktiven Last und der Sperrdiode der betreffenden induktiven Schalteinheit sowie der Gleichspannungsquelle gebildet wird. Dabei wird die Energie der induktiven Last an die Gleichspannungsquelle der Schaltungsanordnung rückgeführt, wodurch sehr wenig Energie in Wärme umgewandelt wird und die Verlustleistung der Schaltungsanordnung minimal ist.

Diese Schaltungsanordnung weist jedoch den gravierenden Nachteil auf, daß die Abschaltdauer, innerhalb der die in der induktiven Last gespeicherte Energie an die Gleichspannungsquelle rückgeführt werden kann, von der Spannung der Gleichspannungsquelle der Schaltungsanordnung abhängig ist.

Dadurch wird die Abschaltdauer der Vier - Quadrantenschaltung gegenüber der klassischen Schaltungsanordnung, besonders bei geringen Spannungen der Gleichspannungsquelle (unterhalb 20 Volt), drastisch erhöht.

Der Erfindung liegt die Aufgabe zugrunde, eine verbesserte Schaltungsanordnung gemäß dem Oberbegriff des Patentanspruchs 1 anzugeben, die vorteilhafte Eigenschaften in Bezug auf die Belastung des Freilaufschalters, auf die Abschaltdauer der induktiven Last sowie auf die beim Abschalten erzeugte Verlustleistung aufweist. Diese Aufgabe wird erfindungsgemäß durch die Merkmale im Kennzeichen des Patentanspruches 1 gelöst.

Im Gebrauch der Schaltung gemäß Anspruch 1 wird beim überschreiten des Schwellenwertes die Schaltgruppe im linearen Betrieb, beispielsweise von einer Regelschaltung, die die Spannung am Freilaufschalter überwacht, soweit aufgesteuert, daß die Spannung im Knotenpunkt nicht weiter ansteigt, und die Energie der induktiven Last an die Gleichspannungsquelle der Schaltungsanordnung rückgeführt wird. Dadurch wird ein Teil der Energie der induktiven Last in der Schaltgruppe in Wärme umgewandelt und ein Teil an den Pluspol der Gleichspannungsquelle rückgeführt.

Als Schaltmittel für die als Schalter fungierende Schaltgruppe im Freilaufkreis ist vorzugsweise ein Metalloxid - Feldeffekttransistor mit einer geeigneten Beschaltung an dessen Gate vorgesehen, welche die Spannung am Knotenpunkt überwacht, und durch welche der Schwellenwert vorgegeben ist.

Vorzugsweise weist der Schwellenwert, bis zu dem der Freilaufkreis gesperrt bleibt, einen Betrag auf, der knapp unterhalb der maximal zulässigen Spannung für die als Schalter fungierende Schaltgruppe und/oder den Freilaufschalter liegt.

In einer vorteilhaften Weiterbildung kann die Schaltungsanordnung aus den Schaltern, Dioden und der Schaltgruppe als integrierte schaltungsanordnung aufgebaut werden.

Durch die Begrenzung der Spannung an der Schaltgruppe des Freilaufkreises auf einen definierten Spannungswert ist die Abschaltdauer der Schaltungsanordnung konstant, d.h. die Abschaltdauer ist unabhängig von der Spannung der Gleichspannungsquelle der Schaltungsanordnung.

In einer letzten vorteilhaften Weiterbildung der Erfindung ist vorgesehen, den Strom durch den Freilaufschalter mittels der Pulsweiten - Modulation zu regeln.

Durch die Belastung der Schaltgruppe im Freilaufkreis mit einem Schwellenwert, und der Möglichkeit, die darüber hinaus gehende Spannung an die Gleichspannungsquelle der schaltungsanordnung rückzuführen, kann das Verhältnis zwischen der Abschaltdauer und der Verlustleistung bei geschützter Schaltgruppe und/oder geschütztem Freilaufschalter frei gewählt werden.

Im folgenden ist die Schaltungsanordnung zum Schalten induktiver Lasten am Ausführungsbeispiel der Induktionsspulen gleichstrombetriebener Magnetventile im Zusammenhang mit der Zeichnung (Figuren 1 - 3) beschrieben.

Es zeigen:
- Figur 1: ein Prinzipschaltbild der Schaltungsanordnung zum Abschalten von Induktionsspulen gleichstrombetriebener Magnetventile.
- Figur 2: ein Diagramm zur Gegenüberstellung der in den Schaltern der Freilaufkreise der beiden eingangs genannten konventionellen Schaltungsanordnungen und der erfindungsgemäßen Schaltungsanordnung in Wärme umgewandelten Energie, aufgetragen über der Spannung der Gleichspannungsquelle.
- Figur 3: ein Diagramm zur Gegenüberstellung der Abschaltdauern der Magnetventile der beiden eingangs genannten konventionellen Schaltungsanordnungen und der erfindungsgemäßen Schaltungsanordnung, aufgetragen über der Spannung der Gleichspannungsquelle.

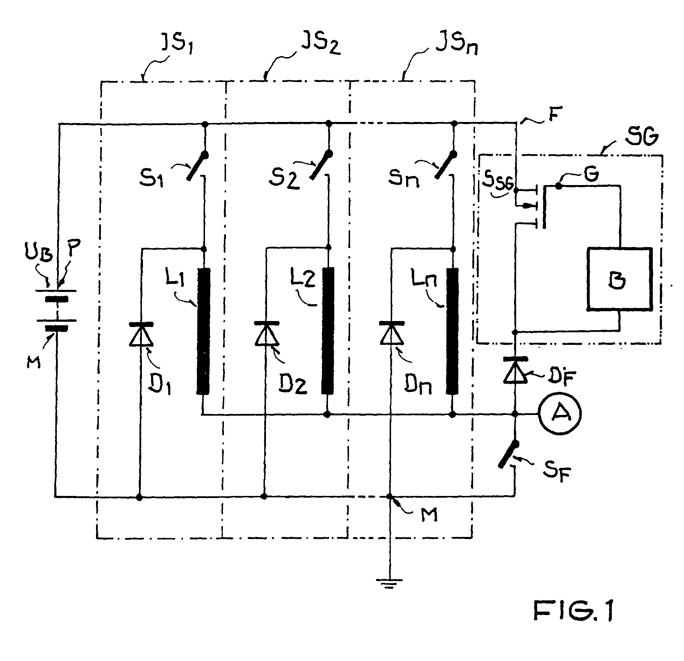

In der Figur 1 ist ein Prinzipschaltbild der Schaltungsanordnung zum unabhängigen Schalten mehrerer parallel geschalteter induktiven Schalteinheiten IS1, IS2, ..., ISn dargestellt. Die induktiven Schalteinheiten IS1, IS2, ..., ISn bestehen dabei die aus den Hauptschaltern S1, S2, ..., Sn, den Induktionsspulen L1, L2, ..., Ln und den Sperrdioden D1, D2, ..., Dn, welche jeweils zwischen einem Hauptschalter S1, S2, ..., Sn und einer Induktionsspule L1, L2, ..., Ln kontaktiert sind und in Sperrichtung mit dem Minuspol M verbunden sind. Parallel zu den induktiven Schalteinheiten IS1, IS2, ..., ISn ist der Freilaufkreis F mit einer Freilaufdiode D_{F}, der Gleichspannungsquelle UB mit dem Minuspol M sowie mit dem Freilaufschalter S_{F} dargestellt. Zwischen die Gleichspannungsquelle UB und den Knotenpunkt A wird in den Freilaufkreis F ein Metalloxid - Feldeffekttransistor S_{SG} mit einer geeigneten Beschaltung B eingefügt, der beim Abschalten mindestens einer induktiven Schaltgruppe IS1, IS2, ..., ISn solange gesperrt bleibt, bis die Spannung am Knotenpunkt A einen Schwellenwert erreicht hat.

Beim Erreichen des Schwellenwertes wird der Metalloxid - Feldeffekttransistor S_{SG} von der Beschaltung B über das Gate G im linearen Betrieb soweit aufgesteuert, daß die Spannung am Knotenpunkt A nicht weiter ansteigt und konstant bleibt.

Der Strom der betreffenden Induktionsspulen L1, L2, ..., Ln fließt nun in einem Stromkreis aus der Freilaufdiode D_{F}, dem Metalloxid - Feldeffekttransistor S_{SG}, der Gleichspannungsquelle UB und den betreffenden Sperrdioden D1, D2, ..., Dn.

Als Beschaltung B des Metalloxid - Feldeffekttransistors S_{SG} ist eine Regelschaltung zwischen dem Knotenpunkt A und dem Gate - Anschluß G des Metalloxid - Feldeffekttransistors S_{SG} vorgesehen, die die Spannung am Knotenpunkt A überwacht und beim Erreichen des durch die Beschaltung B vorgegebenen Schwellenwertes den Metalloxid - Feldeffekttransistor S_{SG} über den Gate - Anschluß G im linearen Betrieb aufsteuert.

Zum beschleunigten Abschalten eines oder mehrerer Induktionsspulen L1, L2, ..., Ln wird der Schwellenwert nahe der maximal zulässigen Spannung für den Freilaufschalter S_{F} gewählt. Wird der Schwellenwert im Knotenpunkt A überschritten, wird weiterhin der Metalloxid - Feldeffekttransistor S_{SG} mit der Spannung in Höhe des Schwellenwertes belastet, und es wird nur der darüber hinausgehende Teil, der von der(den) Induktionsspule(n) L1, L2, ..., Ln in den Freilaufkreis F induziert wird, an die Gleichspannungsquelle UB der Schaltungsanordnung rückgeführt.

Damit ist für den Freilaufschalter S_{F} das Abschalten der Induktionsspule(n) L1, L2, ..., Ln unabhängig von der Spannung der Gleichspannungsquelle UB der Schaltungsanordnung und unabhängig von der in der (den) Induktionsspule(n) L1, L2, ...,Ln gespeicherten Energie.

Die in der (den) Induktionsspule(n) L1, L2, ..., Ln gespeicherte Energie wird dabei zum Teil an die Gleichspannungsquelle UB der Schaltungsanordnung rückgeführt und zum Teil im Metalloxid - Feldeffekttransistor S_{SG} des Freilaufkreises F in Wärme umgewandelt.

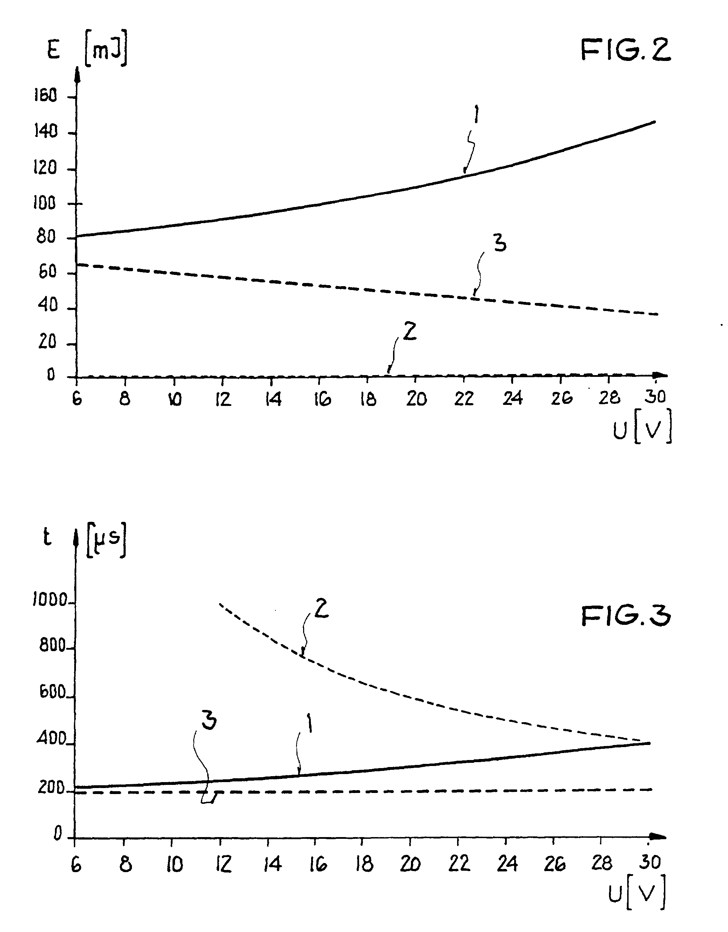

Diese zwei Eigenschaften der erfindungsgemäßen Schaltungsanordnung sind in der Figur 2 und der Figur 3 im Vergleich zu den eingangs genannten konventionellen Schaltungsanordnungen dargestellt.

In der Figur 2 ist in einem Diagramm die in den Schaltern der Freilaufkreise der genannten Schaltungsanordnungen in Wärme umgewandelten Energie E der lnduktionsspulen über die Spannung U der Gleichspannungsquelle UB aufgetragen.

Kurve 1 zeigt, daß die übliche Schaltungsanordnung eine hohe, mit der Spannung U des Gleichspannungsquelle der Schaltungsanordnung zunehmende Belastung des Freilaufschalters aufweist.

Die Kurve 2 der vier - Quadrantenschaltung zeigt keinen Leistungsabfall im Freilaufschalter, da die in den Induktionsspulen der Magnetventile der Vier - Quadrantenschaltung gespeicherte Energie an die Gleichspannungsquelle der Schaltungsanordnung rückgeführt wird. Bei der erfindungsgemäßen Schaltungsanordnung, die in der Kurve 3 wiedergegeben ist, gibt es einen Leistungsabfall im Metalloxid - Feldeffekttransistor S_{SC} des Freilaufkreises F, der Leistungsabfall ist jedoch geringer als bei der üblichen Schaltungsanordnung und nimmt mit steigender Spannung U ab.

In der Figur 3 sind in einem Diagramm die Abschaltdauern t der genannten Schaltungsanordnungen über die Spannung U der Gleichspannungsquelle UB aufgetragen. Kurve 1 zeigt, daß die übliche Schaltungsanordnung eine mit der Spannung U der Gleichspannungsquelle UB zunehmende Abschaltdauer t der Magnetventile aufweist.

Die Kurve 2 der Vier - Quadrantenschaltung zeigt, daß bei kleinen Spannungen U der Gleichspannungsquelle UB, besonders unterhalb 20 Volt, die Abschaltdauer t der Magnetventile extrem zunimmt. Bei der erfindungsgemäßen Schaltungsanordnung, die in der Kurve 3 wiedergegeben ist, ist die Abschaltdauer t der Magnetventile konstant und unabhängig von der Spannung U der Gleichspannungsquelle UB.

Die Regelung des Stromes durch den Freilaufschalter S_{F} beim Bestromen der Induktionsspulen L1, L2, ..., Ln kann durch die Technik der Pulsweiten - Modulation vorgenommen werden.

Somit ermöglicht die erfindungsgemäße Schaltungsanordnung durch geeignete Wahl des Schwellenwertes das Verhältnis zwischen der Abschaltdauer und der Verlustleistung der Schaltungsanordnung vorzugeben, wofür lediglich ein zusätzliches Leistungsbauteil, der Metalloxid - Feldeffekttransistor S_{SG}, benötigt wird.

## Patentansprüche

1. Schaltungsanordnung zum voneinander unabhängigen Schalten mehrerer parallel geschalteter induktiver Schalteinheiten (IS1, IS2, ..., ISn), mit
a) einer Gleichspannungsquelle (UB) mit einem Pluspol (P) und einem Minuspol (M),
b) induktiven Schalteinheiten (IS1, IS2, ..., ISn) aus jeweils
• einer induktiven Last (L1, L2, ..., Ln),
• einem Hauptschalter (S1, S2, ..., Sn) der mit dem Pluspol (P) der Gleichspannungsquelle (UB) und seriell zur induktiven Last (L1, L2, ..., Ln) verbunden ist,
• einer Sperrdiode (D1, D2, ..., Dn), die im Verbindungspunkt der induktiven Last (L1, L2, ..., Ln) und des Hauptschalters (S1, S2, ..., Sn) kontaktiert und in Sperrichtung mit dem Minuspol (M) der Gleichspannungsquelle (UB) verbunden ist,
c) einem Freilaufkreis (F), worin einem Knotenpunkt (A), an dem die nicht an den Hauptschaltern verbundene Ender der Induktiven Lasten (L1, L2, ..., Ln) miteinander verbunden sind, über einen Freilaufschalter (S_{F}) mit dem Minuspol (M) der Gleichspannungsquelle (UB) verbunden ist, und über eine Freilaufdiode (D_{F}) in Durchlaßrichtung mit dem Pluspol (P) der Gleichspannungsquelle (UB) verbunden ist,
**dadurch gekennzeichnet, daß**
zwischen dem Knotenpunkt (A) und dem Pluspol (P) der Gleichspannungsquelle (UB) und seriell zum Freilaufschalter (S_{F}) eine Schaltgruppe (SG) angeordnet ist, die beim Abschalten einer oder mehrerer induktiver Schalteinheiten (IS1, IS2, ..., ISn) den Freilaufkreis (F) solange sperrt, bis die Spannung (U) zwischen den induktiven Lasten (L1, L2, ..., Ln) und der Schaltgruppe (SG) im Knotenpunkt (A) einen Schwellenwert überschreitet.

2. Schaltungsanordnung nach Anspruch 1, **dadurch gekennzeichnet, daß** die induktiven Lasten (L1, L2, ..., Ln) der induktiven Schalteinheiten (IS1, IS2, ..., ISn) als Induktionsspulen (L1, L2, ..., Ln) von Magnetventilen ausgebildet sind.

3. Schaltungsanordnung nach Anspruch 1, **dadurch gekennzeichnet, daß** die Schaltgruppe (SG) im Freilaufkreis (F) einen Metalloxid - Feldeffekttransistor (S_{SG}) mit einer geeigneten Beschaltung (B) aufweist.

4. Schaltungsanordnung nach einem der Ansprüche 1 bis 3, **dadurch gekennzeichnet, daß** der Schwellenwert die maximal zulässige Spannung für den Freilaufschalter (S_{F}) ist.

5. Schaltungsanordnung nach einem der Ansprüche 1 bis 4, **dadurch gekennzeichnet, daß** Freilaufschalter (S_{F}), Freilaufdiode (D_{F}), Sperrdioden (D1, D2, ..., Dn) und Schaltgruppe (SG) als integrierte schaltungsanordnung ausgelegt sind.

6. Schaltungsanordnung nach einem der Ansprüche 1 bis 5, **dadurch gekennzeichnet, daß** die Abschaltdauer (t) der induktiven Schalteinheiten (IS1, IS2, ..., ISn) unabhängig von der Spannung (U) der Gleichspannungsquelle (UB) ist.

7. Schaltungsanordnung nach einem der Ansprüche 1 bis 6, **dadurch gekennzeichnet, daß** ein Teil der im magnetischen Feld der induktiven Schalteinheiten (IS1, IS2, ..., ISn) gespeicherten Energie (E) an die Gleichspannungsquelle (UB) rückgeführt wird.

8. Schaltungsanordnung nach einem der Ansprüche 1 bis 7, **dadurch gekennzeichnet, daß** der Strom durch den Freilaufschalter (S_{F}) mittels Pulsweiten - Modulation regelbar ist.

## Claims

1. Circuit arrangement for the mutually independent switching of a plurality of inductive switch units (IS1, IS2, ..., ISn)connected in parallel, comprising
a) a direct voltage source (UB) having a positive pole (P) and a negative pole (M),
b) inductive switch units (IS1, IS2, ..., ISn) each comprising
* an inductive load (L1, L2, ..., Ln),
* a main switch (S1, S2, ..., Sn), which is connected to the positive pole (P) of the direct voltage source (UB) and serially to the inductive load (L1, L2, ..., Ln),
* a blocking diode (D1, D2, ..., Dn), which contacts the junction of the inductive load (L1, L2, ..., Ln) and the main switch (S1, S2, ..., Sn) and is connected in reverse direction to the negative pole (M) of the direct voltage source (UB),
c) a free-wheeling circuit (F), wherein a junction (A), at which the ends of the inductive loads (L1, L2, ..., Ln) not connected to the main switches are connected to one another, is connected by a freewheeling switch (S_{F}) to the negative pole (M) of the direct voltage source (UB), and is connected in conducting direction by a free-wheeling diode (D_{F}) to the positive pole (P) of the direct voltage source (UB),
**characterized in that**
disposed between the junction (A) and the positive pole (P) of the direct voltage source and serially relative to the free-wheeling switch (S_{F}) is a switch group (SG), which upon the disconnecting of one or more inductive switch units (IS1, IS2, ..., ISn) blocks the free-wheeling circuit (F) until the voltage (U) between the inductive loads (L1, L2, ..., Ln) and the switch group (SG) at the junction (A) exceeds a threshold value.

2. Circuit arrangement according to claim 1, **characterized in that** the inductive loads (L1, L2, ..., Ln) of the inductive switch units (IS1, IS2, ..., ISn) take the form of induction coils (L1, L2, ..., Ln) of solenoid valves.

3. Circuit arrangement according to claim 1, **characterized in that** the switch group (SG) in the free-wheeling circuit (F) comprises a metal-oxide field-effect transistor (S_{SG}) having suitable circuitry (B).

4. Circuit arrangement according to one of claims 1 to 3, **characterized in that** the threshold value is the maximum permissible voltage for the free-wheeling switch (S_{F}).

5. Circuit arrangement according to one of claims 1 to 4, **characterized in that** free-wheeling switch (S_{F}), free-wheeling diode (D_{F}), blocking diodes (D1, D2, ..., Dn) and switch group (SG) are designed as an integrated circuit arrangement.

6. Circuit arrangement according to one of claims 1 to 5, **characterized in that** the break time (t) of the inductive switch units (IS1, IS2, ..., ISn) is independent of the voltage (U) of the direct voltage source (UB).

7. Circuit arrangement according to one of claims 1 to 6, **characterized in that** some of the energy (E), which is stored in the magnetic field of the inductive switch units (IS1, IS2, ..., ISn), is returned to the direct voltage source (UB).

8. Circuit arrangement according to one of claims 1 to 7, **characterized in that** the current through the free-wheeling switch (S_{F}) is controllable by means of pulse-width modulation.

## Revendications

1. Montage pour commuter, indépendamment les unes des autres, plusieurs unités de commutation inductives (IS1,IS2,...,ISn) branchées en parallèle, comportant
a) une source de tension continue (UB) comportant un pôle positif (P) et un pôle négatif (M),
b) des unités de commutation inductives (IS1,IS2,...,ISn) constituées par
- une charge inductive (L1,L2,...Ln),
- un interrupteur principal (S1,S2,...,Sn), qui est relié au pôle positif (P) de la source de tension continue (UB) et est connecté en série avec la charge (L1,L2,...,Ln),
- une diode de blocage (D1,D2,...,Dn), qui est connectée au point de jonction de charge inductive (L1,L2, ...,Ln) et de l'interrupteur principal (S1,S2,..., Sn) et est reliée, dans le sens bloquant au pôle négatif (M) de la source de tension continue (UB),
c) un circuit de roue libre (F), dans lequel un noeud (A), au niveau duquel les extrémités, non reliées aux interrupteurs principaux, des charges inductives (L1,L2,..., Ln) sont reliées entre elles, est connecté par l'intermédiaire d'un interrupteur de roue libre (S_{F}) au pôle négatif (M) de la source de tension continue (UB), et est relié, par l'intermédiaire d'une diode de roue libre (D_{F}), dans le sens passant, au pôle positif (P) de la source de tension continue (UB)
**caractérisé en ce que**
entre le noeud (A) et le pôle positif (P) de la source de tension continue (UB) est branché, et ce en série avec l'interrupteur de roue libre (S_{F}), un module de commutation (SG) qui, lors du débranchement d'une ou de plusieurs unités de commutation inductives (IS1,IS2,..., ISn), bloque le circuit de roue libre (F) jusqu'à ce que la tension (U) entre les sources inductives (L1,L2,...,Ln) et le module de commutation (SG) dépasse une valeur de seuil, au niveau du noeud (A).

2. Montage selon la revendication 1, **caractérisé en ce que** les charges inductives (L1,L2,...,Ln) des unités de commutation inductives (IS1,IS2,...,ISn) sont agencées en tant que bobines d'induction (L1,L2,...,Ln) de soupapes magnétiques.

3. Montage selon la revendication 1, **caractérisé en ce que** le module de commutation (SG) situé dans le circuit de roue libre (F) possède un transistor à effet de champ à oxyde métallique (S_{SG}) comportant un câblage approprié (B).

4. Montage selon l'une des revendications 1 à 3, **caractérisé en ce que** la valeur de seuil est la tension maximale admissible pour l'interrupteur de roue libre (S_{F}).

5. Montage selon l'une des revendications 1 à 4, **caractérisé en ce que** l'interrupteur de roue libre (S_{F}), la diode de roue libre (D_{F}), les diodes de blocage (D1,D2, ...,Dn) et le module de commutation (SG) sont agencés sous la forme d'un montage intégré.

6. Montage selon l'une des revendications 1 à 5, **caractérisé en ce que** la durée de débranchement (t) des unités de commutation inductives (IS1,IS2,...,ISn) est indépendante de la tension (U) de la source de tension continue (UB)

7. Montage selon l'une des revendications 1 à 6, **caractérisé en ce qu'**une partie de l'énergie (E), accumulée dans le champ magnétique des unités de commutation inductives (IS1,IS2,...,ISn), est renvoyée à la source de tension continue (UB).

8. Montage selon l'une des revendications 1 à 7, **caractérisé en ce que** courant traversant l'interrupteur de roue libre (S_{F}) est réglable au moyen d'une modulation d'impulsions en durée.
